(19)

Europäisches Patentamt

European Patent Office

Office européen des brevets

(11) **EP 4 318 557 A1**

(12) **EUROPEAN PATENT APPLICATION**

(43) Date of publication:
**07.02.2024 Bulletin 2024/06**

(21) Application number: **23188785.2**

(22) Date of filing: **31.07.2023**

(51) International Patent Classification (IPC):
***H01L 21/673*** *(2006.01)*

(52) Cooperative Patent Classification (CPC):
**H01L 21/67303; H01L 21/67309**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.08.2022 US 202263370281 P**

(71) Applicant: **ASM IP Holding B.V.
1322 AP Almere (NL)**

(72) Inventors:
• **PIERREUX, Dieter
  1322 AP Almere (NL)**
• **JONGBLOED, Bert
  1322 AP Almere (NL)**
• **ERNUR, Didem
  1322 AP Almere (NL)**

(74) Representative: **V.O.
P.O. Box 87930
2508 DH Den Haag (NL)**

(54) **A WAFER BOAT AND A METHOD FOR FORMING LAYER ON A PLURALITY OF SUBSTRATES**

(57)    A wafer boat and a method for forming a layer on a plurality of substrates that are provided in the wafer boat is disclosed. Embodiments of the presently described wafer boat comprise at least two wafer boat rods, each of which comprising at least a first set of slots for holding a plurality of substrates. The wafer boat further comprises a plurality of plates , whereby at least one slot of the at least first set of slots is provided in between two neighboring plates.

Fig. 1a

EP 4 318 557 A1

**Description**

FIELD OF INVENTION

The present disclosure relates to a semiconductor processing. More specifically, it relates to a wafer boat for use in a semiconductor processing apparatus and to a method for forming a layer on a plurality of substrates arranged in the wafer boat.

BACKGROUND OF THE DISCLOSURE

Vertical furnaces are being used in semiconductor industry for processing a plurality of substrates. The plurality of substrates are loaded into the reaction chamber of the vertical furnaces with the help of a wafer boat that can accommodate the wafers. These furnaces help to carry out processes such as deposition, oxidation, annealing and diffusion. As such, process conditions involving the suitable choice of precursors, provision of the precursors, process temperature and process pressure need to be tailored to carry out the desired process without any compromise on process yield.
One of the challenges associated with processing in vertical furnaces may entail ensuring thickness uniformity of the layer deposited on the substrates during processing. Lack of thickness uniformity may pose challenges in subsequent process steps such as for example patterning and may be inherited to further deposition steps.
There may be a need for improving thickness uniformity of layers formed on substrates that are processed in vertical furnaces.

SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter
It may be an object of the present disclosure to provide wafer boats that offer improved process yield. More specifically, it may be an object to provide and maintain improved thickness uniformity of layers deposited on the plurality of substrates, arranged in wafer boats, during processing. To at least partially achieve this goal, the present disclosure may provide a wafer boat, a vertical furnace and a method as defined in the independent claim. Further embodiments are provided in the dependent claims.
In a first aspect, the present disclosure relates to a wafer boat for use in a semiconductor processing apparatus. The wafer boat may comprise at least two wafer boat rods, each wafer boat rod comprising at least a first set of slots. The first set of slots may be constructed and arranged for receiving a plurality of substrates. A plurality of plates may be provided to the wafer boat with at least one slot of the at least first set of slots being provided in between two neighboring plates.
The inventive wafer boat according to the first aspect may allow for obtaining a layer thickness of the layer formed, across each of the plurality of substrates to be substantially the same. Substantially the same layer thickness may be obtained by having substantially the same growth rate when forming the layer on the surface of each of the plurality of substrates. This may provide the advantage of reducing wafer within non-uniformity (WIWNU) across the surface of each of the plurality of substrates
It may be an advantage of embodiments of the first aspect that process yield of subsequent processes such as for example, lithography, etch, oxidation, diffusion and further deposition processes, may be improved thanks to the reduced WIWNU.
It may be an advantage of embodiments of the first aspect that the performance of devices obtained through processing involving forming of layers may be improved thanks to the reduced WIWNU.
In a second aspect, the present disclosure relates to a method for forming a layer on a plurality of substrates. The method may comprise providing the plurality of substrates into a reaction chamber, the plurality of substrate being arranged in a wafer boat according to embodiments of the first aspect of the present disclosure. The method may further comprise executing a deposition cycle. The deposition cycle may comprise providing, into the reaction chamber, a precursor for forming the layer on the plurality of substrates.
It may be an advantage of embodiments of the second aspect that WIWNU of each of the substrates may be improved. Improvement of WIWNU may lead to a reduction in thickness non-uniformity of the layer formed across the surface of each substrate of the plurality of substrates. This may be further advantageous in improving the process yield.
It may be an advantage of embodiments of the second aspect that WIWNU of the substrates may be improved for films formed by chemical vapor deposition (CVD).
It may be an advantage of embodiments of the second aspect that WIWNU of the substrates may be improved for films formed by atomic layer deposition (ALD).

BRIEF DESCRIPTION OF THE DRAWING FIGURES

The objects and advantages of the inventive concept disclosed in this disclosure will be presented with the help of the appended figures.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure. Like elements will be denoted by like reference numbers unless stated otherwise

Fig. 1a to Fig. 1b : is a schematic cross-section of a wafer boat provided with a plurality of planar plates and plurality of substrates.

Fig. 2a and Fig. 2c : is a schematic representation of differing hole density across the surface of each plate of the plurality of plates.

Fig. 2b and Fig. 2d : is a schematic representation of changing depth of the blind-holes across the surface of each plate of the plurality of plates.

Fig. 3a to Fig. 3f : show schematic cross-sections of a wafer boat provided with a plurality of concave-shaped plates positioned alternatingly and repeatedly with the plurality of substrates.

Fig. 4a and Fig. 4b : show schematic cross-section of a wafer boat provided with a plurality of convex-shaped plates positioned alternatingly and repeatedly with the plurality of substrates.

Fig. 5a: Film thickness on the substrate as a function of measurement points.

Fig. 5b: 49 point polar map measurement for measuring thickness of the film on the substrate.

Fig. 6: is a schematic side view of a vertical furnace according to embodiments of the first aspect of the present disclosure.

DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents thereof.

The terms first, second, third and the like appearing in the description and the claims are not referring to a specific order or any sequence. They are used to distinguish between similar features or similar elements. It is to be understood that such terms can be interchangeable under suitable conditions and thus, the embodiments of the disclosure described in the description are capable of being used in other sequences than the described ones.

It is to be noticed that the term "comprising", as used herein, should not be interpreted as being restricted to the means listed thereafter. It is to be interpreted as specifying the presence of the stated features, steps or components and thus, does not exclude other elements or steps and does not prevent one or more other steps, components, or features from being present or being added.

Reference throughout the specification to "embodiments" in various places throughout the specification are not necessarily all referring to the same embodiment, but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments, but may.

The following terms are provided solely to help in the understanding of the disclosure.

As used herein and unless provided otherwise, the term *"substantially the same layer thickness"* may refer to edge-to-center thickness of the film formed on the surface of the substrate being in a range of 1 % to 30 % . or less than 1 % depending on the thickness of the film to be formed.

As used herein and unless provided otherwise, the term *"wafer within non-uniformity (WIWNU)"* may refer to the percentage of thickness variation of a layer formed on the surface of the substrate according to:

$$\frac{maximum\ thickness - minimum\ thickness}{average\ thickness} X\ 100$$

As used herein and unless provided otherwise, the term *"planar or flat"* may refer to a surface without any indentations or raised area such that the substrate can be placed on that surface without stability issues.

As used herein and unless provided otherwise, the term *"fully exposed surface"* may refer to a surface of the substrate being exposed to ambient at every point on that surface and being suitable for forming a layer. If a layer is formed on the substrate or if a layer is present on the substrate, then the upper surface of the layer that is exposed to ambient may be referred to as the fully exposed surface of the substrate.

As used herein and unless provided otherwise, the term *"hole density"* may refer to the ratio of the area of the surface occupied by holes to the area of the surface not having holes, the area being defined for a certain region on the surface of a plate.

As used herein and unless provided otherwise, the term *"blind-holes"* may refer to openings having a certain depth and a closed end within the thickness of the plate.

As used herein and unless provided otherwise, the term *"native oxide"* may refer to the oxide layer that is present on a surface as result of natural oxidation in air.

As used herein and unless provided otherwise, the term *"edge effects"* may refer to having an varying thickness of the layer on the surface of the substrate corresponding to the circumferential edge of the substrate compared to other parts of the surface of the substrate.

As used herein and unless provided otherwise, the term *"reaction temperature"* may refer to the temperature in the reaction chamber during the formation of the layer on the plurality of substrates.

As used herein and unless provided otherwise, the term *"reaction pressure"* may refer to the pressure in the reaction chamber during the formation of the layer on the plurality of substrates.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

The wafer boat (580) for use in a semiconductor processing apparatus may comprise at least two wafer boat rods (100). Each wafer boat rod (100) may comprise at least a first set of slots (101). The first set of slots (101) may be constructed and arranged for receiving a plurality of substrates (130). A plurality of plates (110, 111, 112, 113, 115, 116) may be provided to the wafer boat (580) with at least one slot of the at least first set of slots (101) being provided in between two neighboring plates.

In other words, it may be stated that the plurality of plates (110, 111, 112, 113, 115, 116) may be positioned, in the wafer boat (580), in such a way that each plate of the plurality of plates may be positioned from a neighboring plate alternatingly an repeatedly with at least one slot of the first set of slots (101) in between them.

In embodiments, the plurality of substrates (130) may comprise a semiconductor layer. This semiconductor layer (10) may, in some embodiments, be a silicon layer. The silicon layer may, in embodiments, be a Si{100}, Si {110} or a Si {111} layer. The plurality of substrates (130) may, in embodiments, be semiconductor substrates. The semiconductor substrates may, in some embodiments, be Si {111} substrates, Si {110} substrates or Si {100} substrates. In some embodiments, the semiconductor substrates may be silicon nitride substrates. In some embodiments, the semiconductor substrates may be Group III-N substrates. The Group III-N substrates may in some embodiments be aluminum nitride or gallium nitride substrates. In embodiments, one or more surface layers may be present or may be formed on the plurality of substrates (130).

In some embodiments, the semiconductor processing apparatus may be a vertical furnace, thereby extending longitudinally in a vertical direction.

In embodiments, each substrate of the plurality of substrates (130) may have a fully exposed surface (131) for forming a layer.

The wafer boat (580) according to embodiments of the first aspect of the present disclosure may be advantageous in tuning the growth of the layer across the fully exposed surface (131) of the substrates. This may be advantageous in cases where non-uniformity may exist in the growth of the layer across the fully exposed surface (131) of the substrates.

In embodiments, the plurality of plates may be provided to the wafer boat (580) being substantially perpendicular to the at least two wafer boat rods (100). This may thus, allow for obtaining a uniform growth rate of the layer across the fully exposed surface of the substrates. The uniform growth rate may help in reducing a thickness non-uniformity of a layer formed on the fully exposed surface (131) of each substrate of the plurality of substrates (130). Reducing thickness non-uniformity may provide a uniform layer thickness across the fully exposed surface (131) of the substrates (130). It is to be understood that the uniform layer thickness may refer to the layer thickness being substantially the same across the fully exposed surface (131) of the substrates (130). This may advantageously be due to the fact that a growth rate of the layer during its formation across the fully exposed surface (131) of the substrates (130) may be substantially the same. Having a uniform layer thickness may allow for improving wafer within non-uniformity (WIWNU) across the fully exposed surface (131) of each of the plurality of substrates (130). This may consequently be advantageous in improving process yield of processes subsequent to the formation of the layer such as for example, lithography, etch and further deposition processes. This may then help to reduce unwanted topography across the surface of the plurality of substrates (130), thereby reducing the risk on device performance and on device integrity.

In some embodiments, each plate of the plurality of plates (110, 111, 112, 113, 115, 116) may be positioned alternatingly and repeatedly, in the wafer boat (580), with each substrate of the plurality of substrates (130). The fully exposed surface (131) of each substrate of the plurality of substrates (130) may thus, be separated from each plate of the plurality of plates (110) by a pre-determined distance (d). The pre-determined distance (d) may allow for obtaining a uniform growth rate of the layer across the exposed surface (131). Without wishing to be bound by theory, it may be stated that the pre-determined distance may allow for optimizing the volume-to-surface area ratio (V/S) between the fully exposed surface (131) of each substrate of the plurality of substrates and each plate of the plurality of substrates (110). The volume may be represented by the volume present in between the fully exposed surface (131) of each substrate of the plurality of substrates and each plate of the plurality of substrates (110),. The surface area may be represented by the area available on the fully exposed surface (131) of the substrate (130) for forming a film. For a layer thickness being higher at the edges of the substrates (130) compared to the center, a decreased volume-to-surface area ratio at the edges than in the center may advantageously help to lower the growth rate at the edges of the substrates. This may be adjusted as a function of the pre-determined distance (d) such as for example by decreasing the value for pre-determined distance (d).

Conversely, for a layer thickness being lower at the edges of the substrates (130) compared to the center, an increased volume-to-surface area ratio at the edges than in the center may help to, advantageously, increase the growth rate at the edges of the substrates. Balancing the growth rate of the layer formed on the fully exposed surface (131) of the substrate (130), may thus, advantageously help for achieving thickness uniformity of the layer formed across the surface of the substrate. This may also be adjusted as a function of the pre-determined distance (d), such as for example by increasing the value for pre-determined distance (d).

Thus, it may also be stated that variation in the value of pre-determined distance (d) may therefore help to achieve thickness uniformity of the layer formed across the surface of the substrate by way of adjusting the volume-to-surface area ratio. It is to be understood that the pre-determined distance may be a function of at least one of process to be carried out, type of precursor to be used, process temperature, partial pressure of the precursors and process pressure.

In some embodiments, the pre-determined distance may be in the range of 3 mm to 30 mm.

In embodiments, the pre-determined distance (d) may be configured such that a layer thickness of the layer, across the fully exposed surface (131) of each of the plurality of substrates (130) may be substantially the same. This may be advantageous in reducing WIWNU. The configuration of the distance (d) may thus enable designing a wafer boat (580) allowing to have improved thickness uniformity across the fully exposed surface (131) of each of the plurality of substrates (130).

It may be stated that the distance between a lower surface (132) of the substrate (130), which is opposite to the fully exposed surface (131), and an upper surface of the plate (106) may not play a role in obtaining improved thickness uniformity of the layer that is formed across the fully exposed surface (131). Thus, it may just be adjustable once the pre-determined thickness (d) is fixed.

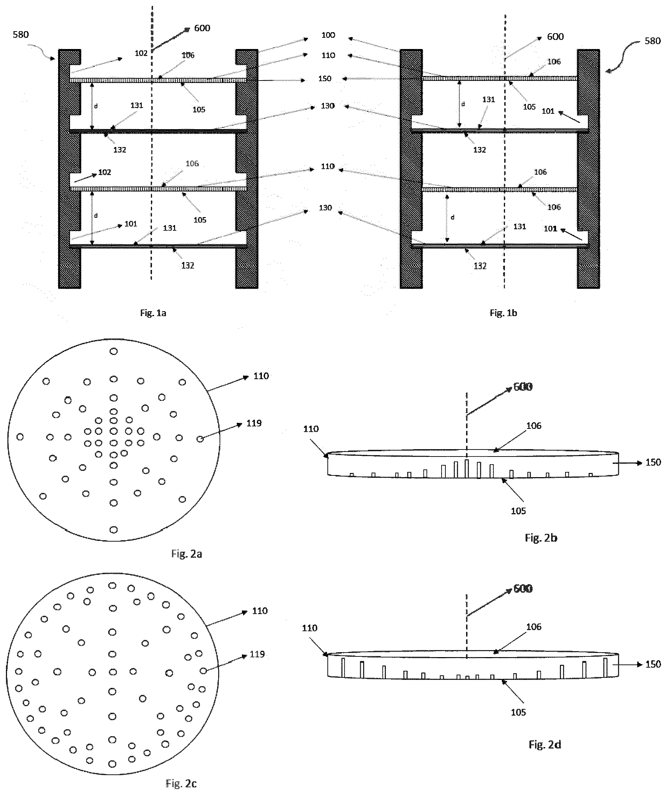

In some embodiments, each wafer boat rod (100) may further comprise a second set of plurality of slots (102). Each plate of the plurality of plates (110) may be receivable in and supported by the second set of plurality of slots (102) and each slot of the second set of plurality of slots (102) being separated alternatingly and repeatedly from each slot of the first set of plurality of slots (101) (Fig. 2a). This presence of the first set of plurality of slots (101) and the second set of plurality of slots (102) may thus, allow for alternatingly and repeatedly placement of each of the plurality of substrates (130) with respect to each of the plurality of plates (110). This configuration of placement of the substrates (130) and the plates (110) in the wafer boat (580) may advantageously allow that fully exposed surface (131) of each of the substrates (130) faces each of the plates (110). The plurality of plates being receivable in the second set of plurality of slots (102) may allow for easy cleaning when needed. It is to be understood that during processing in the vertical furnace (500), deposition may also take place on the plates (110). Therefore, when the plates are receivable (Fig. 2a) in the wafer boat (580), they may easily be removed and cleaned at a cleaning station. It may also be possible to let the deposited film grow on the plates (110) until a certain thickness and then replace the plates with new ones.

In some embodiments, each plate of the plurality of plates (110) may be integrated with the wafer boat rods (100). Each plate of the plurality of plates (110) may be further positioned alternatingly and repeatedly with each slot of the first set of plurality of slots (101) (Fig. 2b). As each substrate of the plurality of substrates (130) may be positioned in each slot of the first set of plurality of slots (101), alternated and repeated configuration of each substrate with each plate may again be obtained in the wafer boat (580). This may advantageously provide mechanical stability in the wafer boat (580). Due to stress that may be created on the plates as a result of processing, the plates may move from the slots. Therefore, having plates integrated with the wafer boat rods (100) may help to overcome this problem.

In embodiments, each plate of the plurality of plates (110) may have a surface facing the fully exposed surface (131) of the substrate (130) wherein an area of the surface may vary at every position from the central axis (600) towards a circumferential edge (150) of the plate (110).

Variation of the surface area may lead to a change in the volume in between the exposed surface (131) of the substrate and the surface (105) of the plate (110) facing the exposed surface (131) of the substrate (130). This volume may be defined in between the exposed surface (131) of the substrate and the surface (105) of the plate (110) facing the exposed surface (131) of the substrate (130) extending over the pre-determined distance (d).

In embodiments, each plate of the plurality of plates may be planar and the surface (105) of the plate (110) facing the fully exposed surface (131) of the substrate (130) may comprise holes. The holes may have a hole density varying across the surface (105) of the plate (110). This may be advantageous to change locally the surface area of the surface of each plate of the plurality of plates that face the fully exposed surface (131) of each substrate (130) of the plurality of substrates.

Thus, in other words, the area of the surface (105) of the plate (110) facing the fully exposed surface (131) of the substrate (130) may be changing at every point across the surface of the plate (105) going from the central axis (600) circumferentially towards the circumferential edge (150) of the plate (110). The varying hole density may provide for changing the volume, at every point, defined in between the exposed surface (131) of the substrate and the surface (105) of the plate (110) facing the exposed surface (131) of the substrate (130) extending over the pre-determined distance (d). This may thus, lead to a change in the volume-to-surface area ratio going from the central axis (600) circumferentially towards the circumferential edge (150) of the plate (110) in the region defined between the surface (105) of the plate (110) facing the fully exposed surface (131) of the substrate (130) and the fully exposed surface (131) of the substrate (130) itself.

This may thus, compensate for the change in growth rate of the layer across the exposed surface of the substrate (131), thereby making the growth rate substantially the same across the exposed surface of the substrate (131). This may then advantageously lead to a uniform layer thickness and reducing thickness non-uniformity of the layer formed across the exposed surface of the substrate (131).

In embodiments, as exemplified in Fig. 1a, Fig. 1b and Fig. 2, the plates (110) may be planar such that the surface (105) of the plate (110) facing the fully exposed surface (131) of the substrate (130) and an upper surface (106) of the plate (110) opposite to that surface (105) are parallel to each other.

Now we refer to Fig. 2a and Fig. 2c showing a schematic representation of differing hole density across the surface of each plate of the plurality of plates.

Fig. 2a schematically represents a plate (110) where the hole density is higher in the center of the plate and decreases, at every point, when going away from the center circumferentially towards the edge (150) of the plate (110). In some embodiments, the hole density around a central portion of the surface (105) of the plate (110) may be higher than that in a circumferential edge (150) of the plate (110) (Fig. 2a). This may allow for creating more volume corresponding around a central region compared to a circumferential region of the volume defined in between the exposed surface (131) of the substrate (130) and the surface (105) of the plate (110) facing the exposed surface (131) of the substrate (130). More volume obtained in this way around the central portion may advantageously help to increase the growth rate in the central region of the fully exposed surface (131) of the substrate (130) and thus, helping to balance the growth rate of the layer in comparison to the circumferential region. This may then lead to a uniform layer thickness and reduced thickness non-uniformity of the layer formed across the exposed surface (131) of the substrate (130). This may thus, be advantageous when higher layer thickness of the film is formed around the circumferential region of the substrate (130) compared to that in its central region.

Depositions carried out by using silicon-containing precursors such as for example, di-silane, tri-silane, TEOS may require having more volume created around a central region of the fully exposed surface (131) of the substrate (130), thereby balancing out the possible formation of higher film thickness on the circumferential edge of the substrate (130).

Fig. 2c schematically represents a plate (110) where the hole density may be lower in the center of the plate (110) and increases, at every point, when going away from the center circumferentially towards the edge (150) of the plate (110). Thus, in some embodiments, the hole density around a central portion of the surface (105) of the plate (110) may be lower than that in the circumferential edge (150) of the plate (110) (Fig. 2c). This may allow for creating less volume corresponding around the central region compared to the circumferential region of the volume defined in between the exposed surface (131) of the substrate (130) and the surface (105) of the plate (110) facing the exposed surface (131) of the substrate (130). Less volume obtained in this way around the central portion may advantageously help to decrease the growth rate in the central region of the fully exposed surface (131) of the substrate (130). This may thus, be advantageous when higher layer thickness of the film is formed around the central region of the substrate (130) compared to that in its circumferential region. This may allow for balancing the growth rate of the of the layer thereby, helping to have a uniform layer thickness and reduced thickness non-uniformity of the layer formed across the exposed surface (131) of the substrate (130).

In embodiments, where the hole density may vary across the surface (105) of the plate (110) as schematized in Fig. 2a and Fig. 2c, the size of each of the holes may be the same. The size may refer to the width and the depth of the holes. In other words, size may refer to the volume of each of the holes and the surface area of the opening defining each of the holes.

In embodiments, the holes (119) may be in the form of blind-holes. Therefore, the depth of the blind-holes may extend within the thickness of the plates (110). This could be advantageous in taking precaution to suppress the thickness of the layer either in a central region of the exposed surface (131) of the substrate (130) or on the region around the circumferential edge depending on which region a thicker film grows.

In embodiments, the blind-holes may be constructed and arranged to have varying depths at every point from the central axis (600) towards a circumferential edge (150) of each plate of the plurality of plates (110). In these embodiments, the blind-holes may be distributed equally throughout the surface (105) of the plate (110), thereby having identical hole density across the surface (105) of the plate (110). The width of the blind-holes may be kept the same, in other words, the surface area of the opening defining each of the blind-holes on the surface (105) may be kept the same.

In some embodiments, the depth of the blind-holes may be configured such that a depth of a first set of blind-holes around the central region of the plate (110) may be higher than a depth of a second set of blind-holes around the circumferential edge (150) of the plate (110) so that more volume around the central region compared to the circumferential region of the plate (110) may be obtained. In these embodiments, the depth of the blind-holes may gradually decrease at every point from the central axis (600) towards a circumferential edge (150) as schematized in Fig. 2b. The higher depth of blind holes around the central region of the plate may thus, provide an increased volume in between the plate (110) and the fully exposed surface (131) of the substrate (130). This may lead to an increase in the growth rate of the layer on the fully exposed surface (131) of the substrate (130), thereby leading to an increase in thickness around the central region of the fully exposed surface (131) of the substrate (130). This may help to balance the thickness and improve thickness uniformity for processes that end up with thicker layers around the circumferential edge of the fully exposed surface (131) of the substrate (130) compared to its central region.

In some embodiments, the depth of the blind-holes may be configured such that a depth of a first set of blind-holes around the central region of the plate (110) may be lower than a depth of a second set of blind-holes around the circumferential edge (150) of the plate (110) so that less volume around the central region compared to the circumferential region of the plate (110) may be obtained. In these embodiments, the depth of the blind-holes may gradually increase at every point from the central axis (600) towards a circumferential edge (150) as schematized in Fig. 2d. The lower depth of blind holes around the central region of the plate may thus, provide a decreased volume in between the plate (110) and the fully exposed surface (131) of the substrate (130). This may lead to a decrease in the growth rate of the layer on the fully exposed surface (131) of the substrate (130), thereby leading to a decrease in thickness around the central region of the fully exposed surface (131) of the substrate (130). This may help to balance the thickness and improve thickness uniformity for processes that end up with thicker layers around the central region of the fully exposed surface (131) of the substrate (130) compared to that around its circumferential edge.

In embodiments, each plate of the plurality of plates may have a surface (117, 118) facing the fully exposed surface (131) of the substrate (130), wherein a distance (d') between the surface of the plate (117, 118) and the fully exposed surface (131) of the substrate (130) may vary at every position from the central axis (600) towards a circumferential edge (150) of the plate (111, 112, 113, 115, 116). The varying distance (d') may thus, advantageously provide for changing the volume in between the exposed surface (131) of the substrate (110) and the surface (117, 118) of the plate (111, 112) facing the exposed surface (131) of the substrate (130).

This may advantageously allow for obtaining a growth rate of the layer being substantially the same across the surface of the substrate. This may then allow for obtaining a uniform layer thickness and reduced thickness non-uniformity of the layer formed across the exposed surface of the substrate (131).

For reactions involving the need for creation or depletion of gas phase components as a function of the precursor used, the variation of the distance (d') between the surface of the plate (117, 118) and the fully exposed surface (131) of the substrate (130) may help to create increased or decreased volume, respectively, to facilitate the creation or depletion of such components. In other words, the variation of the distance (d') between the surface of the plate (117, 118) and the fully exposed surface (131) of the substrate (130) may help to match the growth rate of the layer to be substantially the same around the central region and the circumferential region of the fully exposed surface (131) of the substrate (130).

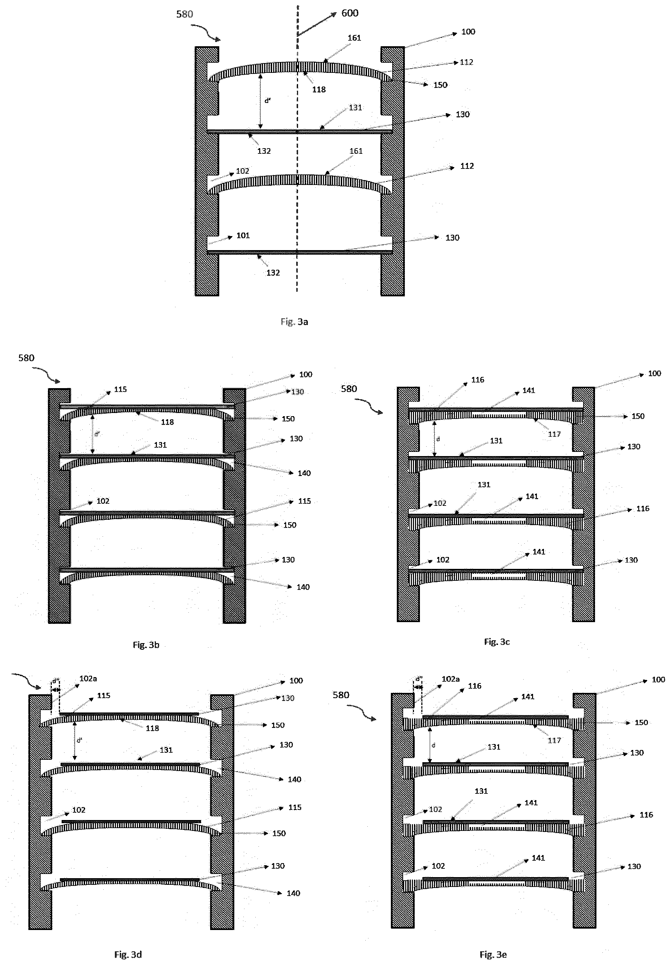

We now return to Fig. 3a to Fig. 3d showing schematically cross-section of a wafer boat provided with a plurality of concave plates (112) positioned alternatingly and repeatedly with the plurality of substrates (130).

In embodiments, each plate of the plurality of plates may be concave-shaped (112) so that the distance (d') decreases at every position from the central axis (600) towards the circumferential edge (150) of the concave-shaped plate (112). It may be stated that the distance between a lower surface (132) of the substrate (130), which is opposite to the fully exposed surface (131), and an upper surface (161) of the concave-shaped plate (112) may not play a role in obtaining improved thickness uniformity of the layer that is formed across the fully exposed surface (131). Thus, this distance may just be adjustable once the distance (d') between the upper surface (131) of the substrate (130) and the lower surface (118) of the concave-shaped (112) plate is determined for obtaining improved thickness uniformity. It is to be understood that the distance between a lower surface (132) of the substrate (130), which is opposite to the fully exposed surface (131), and an upper surface (161) of the concave-shaped plate (112) may therefore be minimized by the design of the wafer boat (580); however, the distance should still allow for loading and unloading of the substrate (130) in the wafer boat (580).

It is to be understood that with plates such as schematically shown in Fig. 3a, the volume of space between fully exposed surface (131) of the substrate (130) and the lower surface (117) of the plate may decreas from the central axis (600) towards the circumferential edge (150) of the concave-shaped plate (112). This may advantageously compensate for the growth of the layer on the fully exposed surface (131) of the substrate (130) when the growth rate around the central region of the substrate (130) is lower than that of the circumferential region of the substrate (130). By enhancing the growth rate around the central region of the substrate and suppressing it around the circumferential region, thickness of the layer may be balanced. This may lead to thickness uniformity of the layer formed across the fully exposed surface (131) of the substrate (130).

In some embodiments, each plate (112) of the plurality of concave-shaped plates may be receivable in and supported by each slot (102) of the second set of plurality of slots; each slot (102) of the second set of plurality of slots being separated alternatingly and repeatedly from each slot (101) of the first set of plurality of slots, whereby each substrate (130) of the plurality of substrates may be receivable in and supported by each slot (101) of the first set of plurality of slots (Fig. 3a).

In some embodiments, each plate (112) of the plurality of concave-shaped plates may be integrated with the wafer boat rods (100) and positioned alternatingly and repeatedly with each slot (101) of the first set of plurality of slots (not shown in the figures).

We now return to Fig. 3b and Fig. 3c showing schematically cross-section of a wafer boat provided with a plurality of concave plates (115, 116) having an at least partially flat surface and being positioned alternatingly and repeatedly with each substrate (1300 of the plurality of substrates.

In embodiments, a surface (161) of the concave-shaped plate (112) opposite to its surface (118) facing the fully exposed surface (131) of the substrate (130) may be at least partially flat so that each substrate (130) of the plurality of substrates may be receivable on and held by the concave-shaped plates (112). This may allow for making optimum usage of the slots comprised in the wafer boat rods (100) without the need to allocate the second set of slots for positioning the plates (115, 116) separately. Furthermore, in this configuration each substrate (130) of the plurality of substrates may still be advantageously positioned alternatingly and repeatedly with each plate (115, 116) of the plurality of concave-shaped plates having the at least partially flat surface.

In some embodiments, the concave-shaped plates (115) may be constructed such that the at least partially flat surface of the plate may be present around a central region of the plate. Thus, thanks to the combination of the concave shape of the plate and its upper surface (161) being partially flat around the central region may allow for the creation of voids (140) bounded by the circumferential edge (150) of the plate (115), wafer boat rod (100) and the circumferential edge of the substrate (Fig. 3b). This may provide the advantage of loading and un-loading of the substrates, via the wafer handling robot, on and off the concave-shaped plates, respectively, thereby allowing the usage of the same slots (102). A fork-shaped wafer handling robot may advantageously be used, in these embodiments, for loading and un-loading of the substrates (130) into the wafer boat (580).

In some embodiments, the concave-shaped plates (116) may be constructed such that the upper surface of the concave shaped-plate may be flat and may comprise a discontinuity (141), thereby forming the at least partially flat surface. As schematically represented in Fig. 3c, as an exemplary embodiment, the discontinuity (141) may provide the advantage of loading and un-loading of the substrates, via the wafer handling robot, on and off the concave-shaped plates, respectively, thereby allowing the usage of the same slots (102).

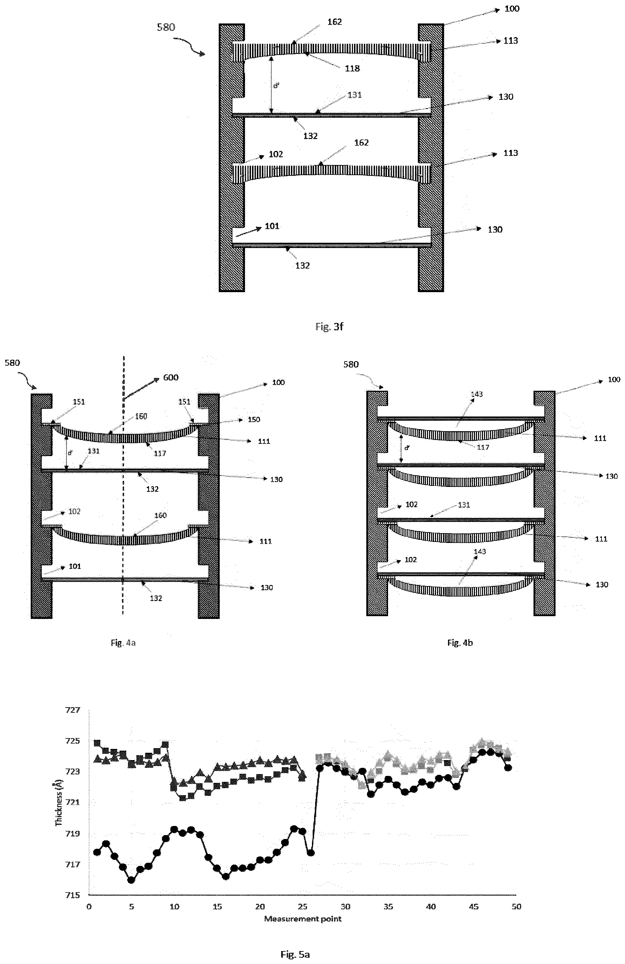

In some embodiments, a surface of the concave-shaped plate (113) opposite to its surface (118) facing the fully exposed surface (131) of the substrate (130) may be fully flat (162). In these embodiments, each plate of the plurality of plates may be receivable in and held by the second set of slots (102) (Fig. 3f) or integrated into the boat rods (100) of the wafer boat (580) (not shown in the figures).

We now return to Fig. 3d and Fig. 3e showing a schematic cross-section of a wafer boat (580) provided with a plurality of concave-shaped plates (115, 116) having at least partially flat surface as shown schematically in Fig. 3b and Fig. 3c, whereby a gap having a separation distance of d" may exist between the boat rod (100) and the edge of the substrate (130). The presence of the gap (d") may further provide the advantage of levelling out or in other words for balancing the growth rate across the surface (131) of the substrate(130), thereby helping to reduce thickness of the layer around the circumferential edge of the substrate. This may provide obtaining thickness uniformity of the layer across the surface (1310 of the substrate (130). Thus, in some embodiments, the wafer boat (580) may be constructed and arranged for having the boat rods (100) being placed further from one another such that a gap (d") may be created between an edge (102a) of the wafer boat slot (102) and edge of the substrate (130), thereby, reducing edge effects.

We now return to Fig. 4a showing a schematic cross-section of a wafer boat (580) provided with a plurality of convex-shaped plates (111) positioned alternatingly and repeatedly with the plurality of substrates (130).

In embodiments, each plate of the plurality of plates may be convex-shaped (111) so that that the distance (d') increases at every position from the central axis (600) towards the circumferential edge of the plate (150). It may be stated that the distance between a lower surface (132) of the substrate (130), which is opposite to the fully exposed surface (131), and an upper surface (160) of the convex-shaped plate (111) may not play a role in obtaining improved thickness uniformity of the layer that is formed across the fully exposed surface (131). Thus, this distance may just be adjustable once the distance (d') between the upper surface (131) of the substrate (130) and the lower surface (117) of the convex-shaped (111) plate is determined for obtaining improved thickness uniformity. It is to be understood that the distance between a lower surface (132) of the substrate (130), which is opposite to the fully exposed surface (131), and an upper surface (160) of the convex-shaped plate (111) may therefore, be minimized by the design of the wafer boat (580); however, the distance should still allow for loading and unloading of the substrate (130) in the wafer boat (580).

Each of the plurality of convex-shaped plates (111) may be received in and held by the second set of slots (102). In order to facilitate the positioning of the convex-shaped plates in these slots, the plates may comprise hooks (151) for making them receivable and holdable in the slots (102).

Use of convex-shaped plates may also offer the advantage of optimum usage of the slots (102) comprised in the wafer boat rods (100) without the need to allocate the second set of slots for positioning the plates (115, 116) separately, such that each plate (111) and each substrate (130) of the plurality of plates and plurality of substrates, respectively may be receivable and held in the same slots. This is schematically represented in Fig. 4b.

Thus, in embodiments, the substrates (130) may be receivable on and held by the convex-shaped plates (111). The substrates (130) may make a contact with the convex-shaped plate (111) through a contact area defined by a surface area of the hooks (151). In a configuration, such as schematized in Fig. 4b, each substrate (130) of the plurality of substrates may still be positioned alternatingly and repeatedly with each convex-shaped plate (111) of the plurality of plates. A gap (143) may be created in between the substrate (130) and the convex-shaped plate (111) in each slot, thereby allowing the substrate (130) to be loaded and unloaded into the wafer boat (580).

When forming the layer on the fully exposed surface (131) of the plurality of substrates (130), some deposition may also occur on the surface (105, 117, 118) of the plates (110, 111, 112, 113, 115, 116) that face the fully exposed surface (131) of the substrates (130) and also on the surface (106, 160, 161, 162) opposite to those surfaces (110, 111, 112, 113, 115, 116). The deposited layer may need to be removed after a certain number of process runs in order to keep benefitting from obtaining thickness uniformity of the layer across the fully exposed surface (131) of the substrates(130). The deposited layer may be removed from the plates by means of an etching process. Therefore, it may be advantageous that the plates are resistant to etching. This may allow for re-use of the plates and at the same time being able to protect the surface integrity of the plates after etching is completed.

In embodiments, each plate (110, 111, 112, 113, 115, 116) of the plurality of plates may comprise silicon and each plate (110, 111, 112, 113, 115, 116) may further comprise a layer of silicon oxide at a distal end.

In embodiments, the distal end may comprise at least the surface (105, 117, 118) of the plate facing the fully exposed surface (131) of the substrate (130). This may advantageously allow for obtaining thickness uniformity of the layer formed on the fully exposed surfaces (131) of the substrates (130).

In some embodiments, each plate (110, 111, 112, 113, 115, 116) of the plurality of plates may comprise silicon and each plate (110, 111, 112, 113, 115, 116) may further comprise the layer of silicon oxide at both distal ends. In other words, the plates may comprise the layer of silicon oxide on the surface (105, 117, 118) facing the fully exposed surface (131) of the substrate and the surface opposite to that surface (106, 160, 161, 162).

In some embodiments, the layer of the silicon oxide may be a layer of native oxide.

In some embodiments, the layer of the silicon oxide may be thermal oxide. Thermal oxide may be grown from the silicon comprising plates by using thermal processing as known by the persons skilled in the art.

Fig. 5a presents thickness measurements done on substrates using a 49-point polar map after completing the film formation. The deposited film was a Si layer formed by using a precursor gas comprising silane. The substrates are placed alternatingly and repeatedly with the silicon comprising plates in the wafer boat. The graph shows a comparison of thickness measurements done using a silicon comprising plate (full circles), a silicon comprising plate having a thermal oxide (full triangles) and a silicon comprising plate having a native oxide (full squares). The silicon comprising plates had oxide layer on both sides. The graph exhibits that presence of oxide layer on the silicon comprising plates (full triangles, full squares) provides advantageously improved uniform thickness of the layer across the surface of the substrate in comparison when silicon comprising plates (full circles) without any oxide layer were used.

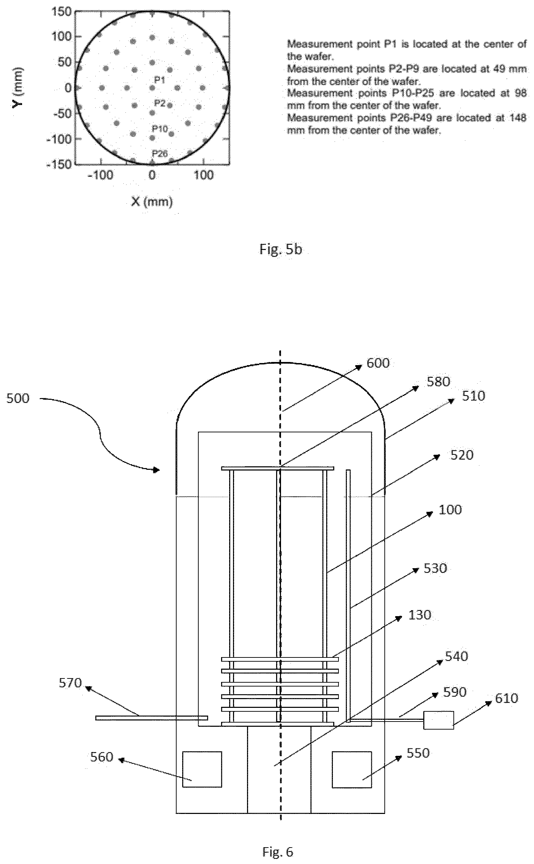

Fig. 5b show where the 49 points for performing the thickness measurement are located on the substrate. Measurement point P1 is located at the center of the substrate (130). Measurement points P2-P9 are located at 49 mm from the center of the substrate (130). Measurement points P10-P25 are located at 98 mm from the center of the substrate (130). Measurement points P26-P49 are located at 148 mm from the center of the substrate (130).

The present disclosure also relates to a vertical furnace. A schematic side view of a vertical furnace according to embodiments of the present disclosure is given in Fig. 6.

The vertical furnace (500) may comprise a reaction chamber (520). The reaction chamber may be configured for forming a layer on a plurality of substrates (130). The vertical furnace may further comprise a wafer boat (580) according to embodiments of the first aspect of the present disclosure and configured to hold the plurality of substrates (130) and it may be loadable in the reaction chamber (520) along a central axis (600).

In embodiments an outer tube (510) may be comprised in the vertical furnace (500) for forming the furnace.

The vertical furnace (500) may further comprise a gas injector (530) configured and arranged for providing a process gas inside the reaction chamber (520). A gas inlet (590) may be comprised in the vertical furnace (500) for providing the process gas to the gas injector (530). It may further comprise a controller (550). The controller (550) may be configured for enabling the formation of the layer on the plurality of substrates (130) in the reaction chamber (520). The controller (550) may thus, be configured for executing instructions that may be comprised in a non-transitory computer readable medium and may cause the vertical furnace to form the layer on the plurality of substrates. The non-transitory computer readable medium may cover any data storage medium such as for example, external hard drives, CDs and DVDs. Furthermore, the vertical furnace may comprise a heater (560). The heater (560) may be configured for heating and maintaining reaction temperature in the reaction chamber (520). The heater may provide the advantage of bringing the reaction chamber (520) to the required temperature to carry out the formation of the layer. An exhaust gas outlet (570) may be provided for removing the process gas out of the reaction chamber (520). The vertical furnace (500) may further comprise a pedestal (540) for supporting the wafer boat (580). The vertical furnace (500) may further comprise a pressure controller that may be configured for attaining and maintaining reaction pressure in the reaction chamber (520). The vertical furnace (500) may comprise at least one precursor storage module (610).

In a second aspect, the present disclosure relates to a method for forming a layer on a plurality of substrates. The method may comprise providing the plurality of substrates into a reaction chamber (520). The reaction chamber may be comprised in a vertical furnace (500) according to embodiments of the present disclosure. The plurality of substrates may be arranged in a wafer boat according to embodiments of the first aspect of the present disclosure. The method may further comprise executing a deposition cycle. The execution of the deposition cycle may comprise providing, into the reaction chamber (520), a precursor for forming the layer on the plurality of substrates (130).

The method may provide the advantage for forming the layer on each of the plurality of substrates (130) with improved thickness uniformity. in other words, this may imply having a film formed on the surface (131) of the substrate, the film having substantially the same layer thickness across the surface of the substrate (130).

It may be another advantage of the method that the yield of the process carried out in the vertical furnace according to embodiments of the first aspect of the present disclosure may be improved. This may the advantageously contribute to an improved yield of subsequent process such as further depositions, lithography and etch thanks to the uniform thickness variation obtained in the vertical furnace.

In some embodiments, the deposition cycle may lead to the formation of the layer by a chemical vapor deposition (CVD) process.

In some embodiments, the deposition cycle may lead to the formation of the layer by an atomic layer deposition (ALD) process.

Therefore, in some embodiments, the deposition cycle may be executed a plurality of times and it may comprise a first deposition pulse. The first deposition pulse may comprise providing a first precursor into the reaction chamber (520). The first deposition pulse may be followed by a first purge pulse, the first purge pulse being further comprised in the deposition cycle. The first purge pulse may be suitable for removing a portion of the first precursor from the reaction chamber (520). The portion of the first precursor may refer to an unreacted portion of the first precursor remaining in the reaction chamber (520). The deposition cycle may further comprise a second deposition pulse. The second deposition pulse may comprise providing a second precursor into the reaction chamber (520). The second deposition pulse may be followed by a second purge pulse, the second purge pulse being further comprised in the deposition cycle. The second purge pulse may be suitable for removing a portion of the second precursor from the reaction chamber (520). The portion of the second precursor may refer to an unreacted portion of the second precursor remaining in the reaction chamber (520).

In embodiments the layer formed may be one of a semiconductor layer, a doped semiconductor layer, a dielectric layer or a metal layer.

In some embodiments, the semiconductor layer or the doped semiconductor layer may comprise a Group-IV semiconductor material.

In some embodiments, the semiconductor layer or the doped semiconductor layer may comprise Group III-N material.

In some embodiments, the semiconductor layer or the doped semiconductor layer may comprise Group III-V material.

In embodiments, the dielectric layer may comprise a metal oxide, metal carbide or a metal nitride.

The embodiments of the present disclosure do not limit the scope of invention as these embodiments are defined by the claims appended herein and their legal equivalents. Any equivalent embodiments are intended to be within the scope of this invention. Modifications of the disclosure that are different from one another, in addition to those disclosed herein, may become apparent to those skilled in the art. Such modifications and the embodiments originating therefrom, are also intended to fall within the scope of the claims appended herein.

**Claims**

1. A wafer boat for use in a semiconductor processing apparatus, the boat comprising:

   - at least two wafer boat rods (100), each wafer boat rod comprising at least a first set (101) of slots, the first set of slots being constructed and arranged for receiving a plurality of substrates,

   wherein a plurality of plates (110, 111, 112, 113, 115, 116) is provided to the wafer boat with at least one slot of the at least first set (101) of slots being provided in between two neighboring plates.

2. The wafer boat according to claim 1, wherein the plurality of plates is provided to the wafer boat being substantially perpendicular to the at least two wafer boat rods (100).

3. The wafer boat according to claim 1, wherein each wafer boat rod (100) further comprises a second set (102) of slots and wherein each plate (110, 111, 112, 113, 115, 116) of the plurality of plates are provided in and supported by the second set (102) of slots , each slot of the second set (102) of slots being separated alternatingly and repeatedly from each slot of the first set (101) of slots.

4. The wafer boat according to claim 1 or 2, wherein each plate (110, 111, 112, 113, 115, 116) of the plurality of plates is integrated with the wafer boat rods (100) and positioned alternatingly and repeatedly with each slot of the first set (101) of slots.

5. The wafer boat according to any one of claims 1-4, wherein each substrate of the plurality of substrates (130) has a fully exposed surface (131) for forming a layer and wherein each plate of the plurality of plates has a surface (105) facing the fully exposed surface (131) of the substrate (130), wherein an area of the surface varies at every position from the central axis (600) towards a circumferential edge (150) of the plate (110).

6. The wafer boat according to claim 5, wherein each plate of the plurality of plates is planar and the surface (115) of the plate (110) facing the fully exposed surface (131) of the substrate (130) comprises holes (119), the holes having a hole density varying across the surface of the plate (105).

7. The wafer boat according to claim 6, wherein the hole density around a central portion of the surface (105) of the plate (110) is higher than that in a circumferential edge (150) of the plate (110).

8. The wafer boat according to claim 6 or 7, wherein the holes (119) are in the form of blind-holes.

9. The wafer boat according to any one of claims 1-8, wherein each substrate of the plurality of substrates (130) has a fully exposed surface (131) for forming a layer and wherein each plate (111, 112, 113, 115, 116) of the plurality of plates has a surface (117, 118) facing the fully exposed surface (131) of the substrate (130), wherein a distance (d') between the surface of the plate (117, 118) and the fully exposed surface (131) of the substrate (130) varies at every position from the central axis (600) towards a circumferential edge (150) of the plate (111, 112, 113, 115, 116).

10. The wafer boat according to claim 9, wherein each plate of the plurality of plates is concave-shaped (112, 113, 115, 116) so that the distance (d') decreases at every position from the central axis (600) towards the circumferential edge (150) of the plate (112, 113, 115, 116).

11. The wafer boat according to claim 10, wherein a surface (161) of the concave-shaped plate opposite to its surface (118) facing the fully exposed surface (131) of the substrate (130) is at least partially flat so that each substrate of the plurality of substrates (130) is receivable on and held by the concave-shaped plates (112, 113, 115, 116).

12. The wafer boat according to claim 9, wherein each plate of the plurality of plates is convex-shaped (111) so that that the distance (d') increases at every position from the central axis (600) towards the circumferential edge (150) of the plate (111).

13. The wafer boat according to claim 12, wherein the substrates are receivable on and held by the convex-shaped plates (111).

14. The wafer boat according to any one of claims 1-13, wherein each plate (110, 111, 112, 113, 115, 116) of the plurality of plates comprises silicon and wherein each plate further comprises a layer of silicon oxide at least on the surface (105, 117, 118) facing the fully exposed surface (131) of the substrate (130).

15. A vertical furnace (500) comprising:

- a reaction chamber (520) configured for forming a layer on a plurality of substrates (130), and;
- a wafer boat (580) according to any one of claims 1-14 and being loadable in the reaction chamber (520) along a central axis (600),
- a heater configured for heating and maintaining reaction temperature in the reaction chamber (520),
- a pressure controller configured for attaining and maintaining reaction pressure in the reaction chamber,
- at least one precursor storage module,
- a controller configured for executing instructions comprised in a non-transitory computer readable medium, and to cause the vertical furnace to form the layer on the plurality of substrates.

16. A method for forming a layer on a plurality of substrates, the method comprising:

- providing a plurality of substrates into a reaction chamber, the plurality of substrates being arranged in a wafer boat according to any one of claims 1-14,
- executing a deposition cycle comprising providing, into the reaction chamber, a precursor for forming the layer on the plurality of substrates.

17. The method according to claim 16, wherein the deposition cycle is executed a plurality of times and wherein the deposition cycle comprises:

- a first deposition pulse comprising a provision of a first precursor into the reaction chamber,
- a first purge pulse for removing a portion of the first precursor from the reaction chamber,
- a second deposition pulse comprising a provision of a second precursor into the reaction chamber,
- a second purge pulse for removing a portion of the second precursor from the reaction chamber.

Fig. 1a

Fig. 1b

Fig. 2a

Fig. 2b

Fig. 2c

Fig. 2d

Fig. 3a

Fig. 3b

Fig. 3c

Fig. 3d

Fig. 3e

Fig. 3f

Fig. 4a

Fig. 4b

Fig. 5a

15

Measurement point P1 is located at the center of the wafer.
Measurement points P2-P9 are located at 49 mm from the center of the wafer.
Measurement points P10-P25 are located at 98 mm from the center of the wafer.
Measurement points P26-P49 are located at 148 mm from the center of the wafer.

Fig. 5b

Fig. 6

16

Europäisches
Patentamt

European
Patent Office

Office européen
des brevets

# EUROPEAN SEARCH REPORT

Application Number

EP 23 18 8785

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/157628 A1 (OKAJIMA YUSAKU [JP]) 19 May 2022 (2022-05-19) | 1,2,5, 9-11, 14-17 | INV. H01L21/673 |
| Y | * paragraph [0031] – paragraph [0115]; | 6,7 | |
| A | figures 1,2,3B * | 8 | |
| X | US 2004/043617 A1 (YOU WEI-MING [TW] ET AL) 4 March 2004 (2004-03-04) * paragraph [0026]; figure 5 * | 1-4, 15-17 | |
| X | US 2009/087807 A1 (YU GUANG-YOU [SG]) 2 April 2009 (2009-04-02) | 1,2, 15-17 | |
| Y | * paragraph [0036] – paragraph [0037]; | 6,7 | |
| A | figures 2A,2B,2D * | 5 | |
| X | US 2008/216742 A1 (TAKEBAYASHI YUJI [JP]) 11 September 2008 (2008-09-11) | 1,2,5,9, 12,13, 15-17 | |
| | * paragraph [0051] – paragraph [0061]; figures 2,6 * | | |

TECHNICAL FIELDS SEARCHED (IPC)

H01L

The present search report has been drawn up for all claims

| Place of search | Date of completion of the search | Examiner |
|---|---|---|
| The Hague | 27 November 2023 | Oberle, Thierry |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

............................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 18 8785

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2023

| Patent document cited in search report | | Publication date | Patent family member(s) | | Publication date |
|---|---|---|---|---|---|
| US 2022157628 | A1 | 19-05-2022 | CN | 114207801 A | 18-03-2022 |
| | | | JP | 7270045 B2 | 09-05-2023 |
| | | | JP | WO2021024385 A1 | 11-02-2021 |
| | | | KR | 20220025888 A | 03-03-2022 |
| | | | TW | 202111850 A | 16-03-2021 |
| | | | US | 2022157628 A1 | 19-05-2022 |
| | | | WO | 2021024385 A1 | 11-02-2021 |
| US 2004043617 | A1 | 04-03-2004 | NONE | | |
| US 2009087807 | A1 | 02-04-2009 | NONE | | |
| US 2008216742 | A1 | 11-09-2008 | JP | 2008258595 A | 23-10-2008 |
| | | | US | 2008216742 A1 | 11-09-2008 |

EPO FORM P0459

For more details about this annex : see Official Journal of the European Patent Office, No. 12/82